# EUROPÄISCHE PATENTSCHRIFT

(11) **EP 2 097 554 B1**
(45) Veröffentlichungstag und Bekanntmachung des Hinweises auf die Patenterteilung: **01.05.2019**
(21) Anmeldenummer: 07847345.1
(22) Anmeldetag: 26.11.2007
(51) Int. Cl.: C23C 14/50, C23C 14/56

(54) **BESCHICHTUNGSANLAGE MIT EINER FUNKVORRICHTUNG UND EINEM MESSGERÄT**
COATING INSTALLATION COMPRISING A RADIO DEVICE AND A MEASURING DEVICE
INSTALLATION D'APPLICATION DE REVÊTEMENT ÉQUIPÉE D'UN DISPOSITIF RADIO ET D'UN APPAREIL DE MESURE

(30) Priorität: 29.11.2006 DE 102006056290
(43) Veröffentlichungstag der Anmeldung: 09.09.2009
(73) Patentinhaber: Leica Microsystems CMS GmbH, 35578 Wetzlar (DE); BANKMANN, Joachim, 37115 Duderstadt (DE)
(72) Erfinder: BANKMANN, Joachim, 37115 Duderstadt (DE); EISENKRÄMER, Frank, 35444 Biebertal (DE)
(74) Vertreter: Schaumburg und Partner Patentanwälte mbB
(86) Internationale Anmeldenummer: PCT/EP2007/062812
(87) Internationale Veröffentlichungsnummer: WO 2008/065075

(56) Entgegenhaltungen:
- GB-A- 2 421 738
- JP-A- 9 256 155
- US-A1- 2002 148 307
- US-A1- 2003 209 097
- HIEBER K: "A novel technique for in situ measurements of thin film properties" THIN SOLID FILMS SWITZERLAND, Bd. 130, Nr. 1-2, 16. August 1985 (1985-08-16), Seiten 125-134, XP002472651 ISSN: 0040-6090

## Beschreibung

Die Erfindung bezieht sich auf eine Beschichtungsanlage mit einer Beschichtungskammer und einem innerhalb der Beschichtungskammer bewegbar angeordneten Substrathalter zur Aufnahme von zu beschichtenden Substraten. Eine solche Beschichtungsanlage geht aus der DE 44 19 167 B4 hervor.

Dünne Schichten mit ihren vielfältigen Eigenschaften und Funktionen nehmen eine bedeutende Rolle im modernen Alltag ein. Insbesondere dünne Schichten mit einer optischen Funktion, z.B. Spiegelschichten, spezielle Filterschichten oder Antireflektionsschichten gewinnen zunehmend an Bedeutung. Dabei sind sowohl Einzelschichten, als auch eine Abfolge von mehreren aufeinander abgeschiedenen Schichten, so genannte Schichtpakete, von Interesse. Dünne Schichten und Schichtpakete lassen sich in evakuierbaren Beschichtungsanlagen auf geeigneten Substraten herstellen. Hierzu verfügt eine solche Beschichtungsanlage zumindest über eine Beschichtungskammer, vorzugsweise eine Vakuumkammer in der sowohl ein zur Aufnahme eines oder mehrerer Substrate geeigneter Substrathalter und eine Materialquelle angeordnet sind.

Der Substrathalter ist vielfach derart in der Beschichtungskammer angebracht, dass eine Bewegung, vorzugsweise eine Rotation des Substrathalters zu einer Bewegung des Substrates in dem von der Materialquelle abgegebenen Partikelstrom führt. Durch eine gezielte Bewegung des Substrates oder mehrerer Substrate in oder durch den Partikelstrom der Materialquelle kann eine definierte Beschichtung des Substrates bzw. der Substrate erreicht werden. Von besonderem Interesse sind in diesem Zusammenhang die Schichtdicke, sowie die Schichtdickenverteilung, also die Homogenität der Beschichtung auf der Oberfläche des Substrates.

Eine Beschichtungsanlage mit einer bewegbaren Drehkalotte als Substrathalter und einer Zerstäuberkathode als Materialquelle geht aus der DE 44 19 167 B4 hervor. Diese Beschichtungsanlage ermöglicht die Herstellung homogener Schichten und Schichtpakete insbesondere auf gläsernen Substraten. Ebenso kann mittels Kodeposition, also der gleichzeitigen Deposition zweier Materialkomponenten, eine Schicht aus einer Legierung oder Mischung eben jener Materialkomponenten auf ein oder mehrere Substrate aufgebracht werden.

Zur Qualitätssicherung der Produktion ist es wünschenswert, nach Möglichkeit schon während des Depositionsprozesses verschiedene charakteristische Parameter der deponierten Schichten zu messen. Bei einer solchen Messung sind unter anderem optische Parameter der Schichten und/oder die Schichtdicke von Interesse.

DE 3610733 A1 offenbart eine Vorrichtung zur Messung der optischen Eigenschaften dünner Schichten während ihrer Deposition. Insbesondere wird das Transmissionsverhalten einer Schicht, während diese in einer Vakuumkammer deponiert wird, gemessen. Die zu vermessende Schicht wird auf ein bewegtes Substrat aufgebracht, welches vorzugsweise gleichmäßig auf einer Kreisbahn bewegt wird. Die Messung erfolgt mittels eines gegenüber der Vakuumkammer ortsfesten Messlichtstrahls. Dieser ermöglicht es, gemäß der gleichmäßigen Kreisbewegung des Substrates, jeweils für einen Bruchteil der Kreisbewegung ein für die aufgebrachte Schicht charakteristisches Messsignal aufzunehmen. Das in der DE 3610733 A1 offenbarte Messkonzept steht jedoch Messungen nicht offen, welche typischerweise über einen längeren Zeitraum an ein und derselben Schicht bzw. an ein und dem selben Substrat erfolgen sollten. Die technischen Probleme hinsichtlich solcher Messungen vergrößern sich bei zunehmender Geschwindigkeit mit der die zu vermessenden Schichten bzw. Substrate innerhalb der Vakuumkammer bewegt werden. Weiterhin ist es mit dem in der DE 3610733 A1 offenbarten Messkonzept nicht möglich, Messdaten von Schichten oder Substraten zu erlangen, die nicht periodisch oder mit sehr langen Periodenlängen in einer Beschichtungskammer bewegt werden.

DE 4314251 A1 offenbart ein Verfahren sowie eine Vorrichtung zur Herstellung optisch absorbierender dünner Schichten. Gemäß der vorstehenden Druckschrift wird ein ortsfest in der Vakuumkammer einer Beschichtungsanlage angebrachtes Testsubstrat vermessen. Die Messung erfolgt über einen ebenfalls gegenüber der Vakuumkammer ortsfesten Messlichtstrahl. Anhand dieses Wertes, werden Rückschlüsse auf die Eigenschaften derjenigen Schichten gezogen, die auf die innerhalb der Vakuumkammer rotierenden Substrate abgeschieden werden. Es handelt sich in diesem Fall also um ein indirektes Messverfahren. Solche Verfahren weisen typischerweise unkalkulierbare Messungenauigkeiten auf.

EP 1050598 B1 offenbart eine Beschichtungsanlage zum Aufdampfen von Vergütungsschichten auf optische Substrate. Die Substrate befinden sich auf einem domförmigen Substrathalter, und laufen der in einer Beschichtungskammer oberhalb einer Verdampferquelle um. Zur Messung der Substrattemperatur ist in der Beschichtungsebene ein Temperaturfühler angebracht, der mit dem umlaufenden Substrathalter verbunden ist. Zur transformatorischen Energieübertragung von dem sich drehenden Substrathalter auf den stationären Teil der Beschichtungsanlage ist eine Primärspule eines Transformators mit dem stationären Teil der Beschichtungsanlage und eine Sekundärspule eines Transformators mit dem sich drehenden Substrathalter verbunden. Primär- und Sekundärspule des Transformators sind berührungsfrei miteinander gekoppelt. Eine Beschichtungsanlage gemäß EP 1050598 B1 ist jedoch technisch aufwändig zu realisieren und wenig flexibel insbesondere hinsichtlich der Bewegung des Substrathalters. So muss konstruktionsbedingt die Energieübertragung über die Primär- und Sekundärspulen des Transformators immer konzentrisch zur Drehachse des Substrathalters erfolgen, da die Primär- und Sekundärspule die Drehachse des Substrathalters umschließen. Die Bewegung des Substrathalters ist somit auf einen einzelnen Drehfreiheitsgrad eingeschränkt. Weiterhin muss der Substrathalter mechanisch hochstabil um seine Drehachse drehbar sein. Veränderungen des Spaltes zwischen der Primär- und Sekundärspule können zu ungewünschten Schwankungen von Induktivitäten und somit Messfehlern führen. Eben jener Spalt zwischen Primär- und Sekundärspule muss ebenfalls gegen Verschmutzung oder Beschichtung geschützt werden. Eine Veränderung der dielektrischen Eigenschaften des Spaltes zwischen der Primär- und Sekundärspule kann zu einer Veränderung der Eigenschaften des Transformators führen, und somit Messfehler verursachen. Weiterhin ist eine Beeinflussung der Eigenschaften der deponierten Schichten denkbar, die auf Substrate aufgebracht werden, die sich in der Nähe der Sekundärspule auf dem Substrathalter befinden. Da die auf Substrate abgeschiedenen Partikel bei typischen Dünnschichtverfahren geladene Partikel sind, können diese z.B. von dem Magnetfeld der Sekundärspule abgelenkt werden. Dies kann zu unerwünschten Veränderungen der Schichteigenschaften führen.

US 5468299 offenbart einen bewegbaren Substrathalter, der auf einem Gaspolster schwebend gelagert ist. Offensichtlich ist das in der EP 1050598 B1 offenbarte Messprinzip insbesondere für eine Beschichtungsanlage mit einem Substrathalter gemäß der US 5468299 nicht geeignet.

JP 09 256155 A offenbart ein Filmabscheidungssystem mit einer Verdampfungskammer. In der Verdampfungskammer sind eine Verdampfungsquelle mit Verdampfungsmaterial und zwei mit Hilfe jeweils eines Elements drehbare Arme angeordnet. Ein Arm weist eine Gasphasenabscheidungshalterung auf, der andere Arm eine Gasphasenabscheidungshalterung, ein Plattenhalter, einen Schichtdickenmonitor sowie einen Sender, welche anscheinend sämtlich mit Hilfe des Elements drehbar um die Längsachse des Arms gelagert sind. Die vom Schichtdickenmonitor gemessenen Messwerte werden vom Sender an den außerhalb der Verdampfungskammer angeordneten Empfänger gesendet.

US 2002/148307 offenbart ein Inspektionssystem zur Benutzung für Prozessvorrichtungen, welches einen Sensor aufweist, welcher mit einem Sender zur drahtlosen Kommunikation und einen außerhalb der Prozessvorrichtung angeordneten Empfänger versehen ist.

GB-A-2 421 738 A offenbart eine Vorrichtung zum Überwachen eines dünnen Films. Die Vorrichtung weist ein doppelt drehbares Planetensystem auf, welches eine zentrale, rotierende Bühne und eine Vielzahl von rotierenden Planeten hat, wobei die Planten in eine entgegengesetzte Drehrichtung wie die Bühne rotieren.

HIEBER K: "A novel technique for in situ measurements of thin film properties" THIN SOLID FILMS SWITZERLAND, Bd. 130, Nr. 1-2, 16. August 1985 (1985-08-16), Seiten 125-134, XP002472651, ISSN: 0040-6090, ist eine wissenschaftliche Veröffentlichung und offenbart eine neue Technik für In-situ-Messungen von Eigenschaften dünner Filme.

US 2003/209097 A1 offenbart eine Sensorvorrichtung für eine nichtintrusive Diagnose einer Halbleiter-Prozessvorrichtung.

Aufgabe der vorliegenden Erfindung ist es, entgegen der bisherigen Praxis, eine Beschichtungsanlage mit einer Beschichtungskammer und einer Messvorrichtung anzugeben, wobei die Messvorrichtung eine einfache und flexible Messung an innerhalb der Beschichtungskammer bewegten Objekten erlauben soll.

Diese Aufgabe wird mit den in Anspruch 1 angegebenen Maßnahmen gelöst. Der Erfindung liegt dabei die Überlegung zugrunde eine Funkverbindung zu nutzen, um innerhalb einer Beschichtungskammer gewonnene Messdaten an einen Ort außerhalb dieser Vakuumkammer zu übertragen. Erfindungsgemäß soll, entgegen der bisherigen Praxis, eine Beschichtungsanlage mit einer Beschichtungskammer und mindestens einem innerhalb der Beschichtungskammer bewegbar angeordneten Substrathalter angegeben werden, wobei der Substrathalter zur Aufnahme von zu beschichtenden Substraten geeignet ist. Die Beschichtungsanlage soll weiterhin ein Messgerät zur Aufnahme von Messwerten innerhalb der Beschichtungskammer aufweisen, welches mechanisch mit dem Substrathalter verbunden ist. Weiterhin soll die Beschichtungsanlage eine Funkvorrichtung mit mindestens einem ersten Funkgerät, welches mit dem Substrathalter verbunden ist, und ein zweites Funkgerät welches zumindest teilweise außerhalb der Beschichtungskammer angeordnet ist, aufweisen. Zwischen den Funkgeräten soll zumindest zeitweise eine Funkverbindung zur Übertragung von Messwerte besteht.

Die mit der vorgenannten Ausgestaltung der Beschichtungsanlage verbundenen Vorteile sind insbesondere darin zu sehen, dass es mittels einer Funkvorrichtung möglich ist, einen Messwert, der von dem Messgerät innerhalb der Beschichtungskammer aufgenommen wird, über flexibel über eine Funkverbindung zwischen Funkgeräten an einen Ort innerhalb und außerhalb der Vakuumkammer zu übermitteln. Eine derartige Übertragung der Messwerte ist insbesondere deshalb vorteilhaft, da der Substrathalter bewegbar in der Vakuumkammer angeordnet ist.

Mittels der erfindungsgemäßen Ausgestaltung der Beschichtungsanlage ist es möglich die technischen Probleme einer drahtgebundenen Übertragung von Messwerten zu überwinden. So kann ein innerhalb der Vakuumkammer angebrachtes Kabel zur Übertragung von Messwerten die Bewegung des Substrathalters beeinflussen oder der sich bewegende Substrathalter könnte das Übertragungskabel beschädigen. Wird der Substrathalter in der Vakuumkammer gedreht, so wäre die Verwendung von Schleifkontakten möglich, um einen Messwert drahtgebunden zu übertragen. Schleifkontakte weisen jedoch eine geringe Zuverlässigkeit auf. Wird ein Schleifkontakt in einer Beschichtungsanlage verwendet, so wird seine Zuverlässigkeit, bedingt durch das in der Beschichtungskammer deponierte Material, zusätzlich verschlechtert.

Eine drahtlose Übermittlung der Messwerte von einem bewegbaren Substrathalter an einen Ort außerhalb der Beschichtungskammer weist weiterhin den Vorteil auf, dass die eigentliche Messwertaufnahme mittels eines einfachen, drahtgebundenen Sensors erfolgen kann, welcher unmittelbar mit dem Messgerät verbunden sein kann. Dies ist nur möglich, da das Messgerät selbst mechanisch mit dem Substrathalter verbunden ist. Auf diese Weise können die technischen Probleme kontaktloser Messverfahren, beispielsweise einer optischen Messung, überwunden werden. Das direkt auf dem Substrathalter angebrachte Messgerät erlaubt es einen oder mehrere Messwerte direkt in der Nähe des oder der Substrate aufzunehmen, und mittels der Funkvorrichtung an einen Ort außerhalb der Vakuumkammer zu übermitteln.

Eine Übermittelung von Messwerten mittels einer Funkverbindung weist weiterhin den erheblichen Vorteil auf, dass der Substrathalter praktisch beliebig in der Beschichtungskammer bewegt werden kann, ohne dass die Funkverbindung unterbrochen werden muss. So kann der Substrathalter entgegen den gängigen technischen Lösungen, wie z.B. einer induktiven Übertragung von Messwerten um mehrere Achsen und Freiheitsgrade gleichzeitig bewegt werden oder auch ohne die Verwendung mechanischer Führung wie einer Achse z.B. auf einem Luftpolster gelagert sein.

Es ergibt sich weiterhin ein erheblicher kommerzieller Vorteil, da mit Hilfe der erfindungsgemäßen Beschichtungsanlage einfache, kostengünstige, drahtgebundene Sensoren für die eigentliche Messwertaufnahme an einem bewegten Objekt innerhalb einer Vakuumkammer verwendet werden können und keine weit reichenden Umbaumaßnahmen an der Beschichtungskammer selbst ergriffen werden müssen.

Weiterhin erlaubt die erfindungsgemäße Beschichtungsanlage die Messwertaufnahme an Substraten, die nicht periodisch oder mit großer Periodenlänge oder in einer Bewegung um viele Freiheitsgrade, in der Beschichtungskammer bewegt werden. Ebenfalls vorteilhaft ist die Möglichkeit Messwerte an einem bewegten Objekt über einen langen Zeitraum hinweg aufzunehmen.

Vorteilhafte Ausgestaltungen der erfindungsgemäßen Beschichtungsanlage gehen aus den von Anspruch 1 abhängigen Ansprüchen hervor. Dabei kann die Ausführungsform nach Anspruch 1 mit den Merkmalen eines Unteranspruches oder auch vorzugsweise mit denen aus mehreren Unteransprüchen kombiniert werden.

Demgemäß kann die Beschichtungsanlage zusätzlich noch folgende Merkmale aufweisen:
- Der Substrathalter kann um eine festgelegte Achse drehbar sein, und als Drehkalotte ausgestaltet sein. Durch eine Ausgestaltung des Substrathalters in Form einer Drehkalotte kann eine homogene Beschichtung der von der Drehkalotte getragenen Substrate erreicht werden. Für die auf diese Weise hergestellten homogenen und somit hochwertigen dünnen Schichten ist es besonders interessant Messwerte zur Charakterisierung der Schichten zu gewinnen. Besonders vorteilhaft können in einer Beschichtungsanlage gemäß dem vorstehenden Ausführungsbeispiel solche Messungen durchgeführt werden.
- In der Beschichtungskammer kann ein um eine festgelegte Achse drehbares Planetengetriebe angeordnet sein. Das Planetengetriebe kann weiterhin dazu geeignet sein, mindestens einen Substrathalter in eine Drehung um eine, zu der Achse des Planetengetriebes, parallelen Achse zu versetzen. Planetengetriebe erlauben es, die auf dem/den Substrathalter/n angebrachten Substrate in eine Bewegung mit einer sehr lagen Periode zu versetzen. D.h. die Substrate gelangen erst nach einer sehr langen Zeit zum wiederholten Mal an denselben Ort in der Vakuumkammer. Auf diese Weise kann eine sehr homogene Beschichtung der Substrate erreicht werden. Das auf dem Substrathalter angebrachte Messgerät erlaubt es, Messwerte an den auf die vorbeschriebene Weise hergestellten Schichten aufzunehmen. Besonders vorteilhaft können durch den Einsatz einer Funkverbindung zu Messwertübertragung die Probleme einer drahtgebundenen Messwertübertragung von sich nahezu unregelmäßig bewegenden Substraten überwunden werden. Ebenfalls vorteilhaft können die technischen Probleme überwunden werden, die aufträten, würde eine sich nahezu unregelmäßig bewegende Probe mit einem kontaktlosen Messverfahren vermessen. Ein an einem festen Ort durch die Vakuumkammer verlaufender Messstrahl würde aufgrund der hohen Periode der Bewegung der Substrate lediglich eine Messung in sehr großen Zeitintervallen erlauben.
- Das Messgerät kann zur Messung mindestens einer physikalischen Größe aus einer Gruppe von physikalischen Größen bestehend aus einer Substrattemperatur, einem Gasdruck, einer elektrischen Spannung, einem elektrischen Widerstand oder einer Schichtdicke einer auf einem zu beschichtenden Substrat abgeschiedenen Schicht, geeignet sein. Die vorgenannten physikalischen Größen stellen wichtige Prozessparameter bei der Herstellung dünner Schichten dar. Eine Messung derartiger physikalischer Größen an einem bewegten Substrat bzw. der auf dem bewegten Substrat befindlichen dünnen Schicht, ist mittels konventioneller kontaktloser Messverfahren sehr aufwändig. Vorteilhaft kann gemäß der vorbeschriebenen Ausgestaltung der Beschichtungsanlage eine besonders effektive, einfache und kostengünstige Art für derartige Messungen angegeben werden.
- Die Beschichtungsanlage kann eine außerhalb der Beschichtungskammer angeordnete Steuereinheit zur Steuerung einer innerhalb der Beschichtungskammer angeordneten Heizung, die mit der Beschichtungskammer verbunden ist, umfassen. Eine der zuvor genannten physikalischen Größen kann ein Steuerparameter der Heizung sein. Die gezielte Steuerung der Substrattemperatur stellt eine wichtige Anforderung an die Herstellung hochwertiger dünner Schichten dar. Besonders vorteilhaft kann durch die zuvor beschriebene Ausgestaltung der Beschichtungsanlage die Heizung, welche die Substrattemperatur bestimmt, mittels eines direkt auf dem bewegbaren Substrathalter gewonnenen Temperaturwertes gesteuert werden.
- Die Beschichtungsanlage kann eine außerhalb der Beschichtungskammer angeordnete Steuereinheit zur Steuerung eines innerhalb der Beschichtungskammer herrschenden Gasdrucks umfassen, und zumindest eine der vorgenannten physikalischen Größen kann ein Steuerparameter des Gasdrucks sein. Besonders vorteilhaft kann durch die zuvor beschriebene Ausgestaltung der Beschichtungsanlage eine Regelung z.B. eines bestimmten Partialgasdruckes am Ort des Substrates erreicht werden.
- Die Beschichtungsanlage kann eine außerhalb der Beschichtungskammer angeordnete Steuereinheit zur Steuerung einer innerhalb der Beschichtungskammer angeordneten Materialquelle, die mit der Beschichtungskammer verbunden ist, umfassen. Zumindest eine der vorgenannten physikalischen Größen kann eine Steuergröße der Materialquelle sein. Vorteilhaft lässt sich mit einer wie zuvor beschriebenen Beschichtungsanlage die Materialquelle anhand von direkt auf dem Substrathalter gemessenen Werten exakt regeln. Insbesondere kann mit Hilfe eines innerhalb der Beschichtungskammer gemessen elektrischen Spannungs- und/oder Widerstandswertes, vorzugsweise einem in Relation zu den Schichteigenschaften oder der Schichtdicke stehenden Spannungs- und/oder Widerstandswertes, die Beschichtung der Substrate aktiv gesteuert werden. Vorteilhaft eröffnet sich mit einer wie zuvor beschrieben Beschichtungsanlage die Möglichkeit die Qualität der hergestellten Schichten zu verbessern.
- Die Beschichtungsanlage kann eine außerhalb der Beschichtungskammer angeordnete Steuereinheit zur Steuerung einer innerhalb der Beschichtungskammer angeordneten Blende zur Abschattung der Materialquelle, die mit der Beschichtungskammer verbunden ist, umfassen. Zumindest eine der vorgenanten physikalischen Größen kann ein Steuerparameter der Blende sein. Vorteilhaft kann in der zuvor beschriebenen Beschichtungsanlage der von der Materialquelle abgegebene Materialstrom anhand von direkt auf dem Substrathalter gemessenen Größen gesteuert werden. So kann z.B. wenn eine gewisse direkt an einem Substrat gemessene Schichtdicke erreicht worden ist, die Materialquelle abgeschattet werden.
- Das erste Funkgerät und/oder das Messgerät sind mit Mitteln zur thermischen Isolation ausgestattet. Zur gezielten Herstellung bestimmter Schichten können in der Beschichtungskammer einer Beschichtungsanlage Temperaturen herrschen, die oberhalb einer kritischen Temperatur liegen, ab welcher elektronische Schaltungen typischerweise dauerhaft Schaden nehmen. Durch eine thermische Isolation des ersten Funkgerätes und/oder des Messgerätes kann deren Zuverlässigkeit bei einem Einsatz innerhalb einer wie zuvor beschriebenen Beschichtungskammer verbessert werden.
- Das erste Funkgerät und/oder das Messgerät können in einem vakuumisolierten Gehäuse untergebracht sein. Bei der Herstellung dünner Schichten kann die Notwendigkeit entstehen eine Beschichtungskammer zu evakuieren. Durch eine Vakuumisolation kann zum einen die Elektronik des Messgerätes und/oder des Funkgerätes vor dem Vakuum z.B. einem ausgasen bestimmter Bauteile geschützt werden, zum anderen kann das in der Beschichtungskammer herrschende Isoliervakuum vor ungewünschten Verunreinigungen geschützt werden.
- Das erste Funkgerät und das Messgerät können in einem gemeinsamen Gehäuse untergebracht sein. Besonders vorteilhaft kann, indem das Funkgerät und das Messgerät in einem gemeinsamen Gehäuse untergebracht werden, der technische Aufwand für die Integration der entsprechenden Bauteile in die Beschichtungskammer verringert werden.
- Die Trägerfrequenz der Funkverbindung kann eine ISM - Frequenz (Industrial Scientific and Medical) sein. Vorzugsweise kann die Trägerfrequenz 27 MHz, 40 MHz, 446 MHz, 860 MHz oder 2,45 GHz betragen. Weiterhin kann die Funkverbindung eine digitale Funkverbindung sein. Vorteilhaft kann für die Funkverbindung eine ISM - Frequenz verwendet werden, da diese Frequenzen anmelde- und gebührenfrei verwendet werden können. Eine Störung anderer elektronischer Bauteile der Beschichtungsanlage kann ebenfalls weitgehend vermieden werden.
- Die Beschichtungskammer kann auf ein Hoch- oder Ultrahochvakuum evakuierbar sein. Zur Herstellung hochwertiger dünner Schichten wird ein geeignetes Isoliervakuum benötigt. Typischerweise ist ein solches Isoliervakuum ein Hoch- oder Ultrahochvakuum. Die Messung physikalischer Größen in der Nähe oder direkt an einem Substrat, bzw. der auf das Substrat aufgebrachten Schicht ist vor allem bei hochwertigen Schichten wünschenswert. Besonders vorteilhaft kann daher die Vakuumkammer der Beschichtungsanlage mit einer Funkvorrichtung und einem Messgerät auf ein Hoch- oder Ultrahochvakuum evakuierbar sein.
- Die Substrate können mit einer dünnen Schicht zu beschichten sein, deren Schichtdicke zwischen 3 nm und 100 µm, insbesondere zwischen 50nm und 100 µm liegt. Dünne Schichten in dem zuvor angegebenen Schichtdickenbereich sind für die technische Anwendung besonders interessant. Folglich ist es unter kommerziellen Gesichtspunkten besonders vorteilhaft die Beschichtungsanlage dahingehend auszugestalten, dass sie zur Herstellung dünner Schichten in dem erwähnten Schichtdickenbereich geeignet ist.
- Die Substrate können mit einem Material zu beschichten sein, welches mindestens eine oxidische Materialkomponente aus einer Gruppe von Materialkomponenten, bestehend aus Si02, Ti02, HfO, TaO, MgF2, Al203, Zr02, PrTiO3, ZnS enthält. Die vorgenannten Materialien sind vor allem für Beschichtungen, wie sie für optische Anwendungen von Interesse sind, relevant. Eine Messung von physikalischen Größen direkt auf einem Substrathalter ist vor allem für die hochwertigen Schichten, wie sie für optische Anwendungen verwendet werden, besonders interessant.
- Die Substrate können mit einem metallischen Material zu beschichten sein. Metallische Schichten können einen Spezialfall optischer Schichten für einen speziellen Wellenlängenbereich, wie z.B. das XUV oder den Röntgenbereich darstellen, daher treffen die gleichen Vorteile wie im vorstehenden Absatz zu.
- Die Substrate können mit einem Mehrfachschichtsystem aus verschiedenen Materialien zu beschichten sein. Mehrfachschichtsysteme sind komplexe Beschichtungen, die insbesondere für hochwertige optische Anwendungen von Interesse sind. Eine Messung physikalischer Größen direkt auf dem Substrathalter ist daher für solche Mehrfachschichtsysteme besonders interessant.

Weitere vorteilhafte Ausgestaltungen der erfindungsgemäßen Beschichtungsanlage gehen aus den vorstehend nicht angesprochenen Unteransprüchen sowie insbesondere aus der Zeichnung hervor. Dabei zeigen deren
- Figur 1: eine Beschichtungsanlage mit einer Drehkalotte als Substrathalter und einer in die Beschichtungsanlage integrierte Messvorrichtung mit einer Funkvorrichtung zur Übertragung der Messdaten,
- Figur 2: eine Detailansicht der Messvorrichtung bestehend aus einem Messgerät und einem ersten Funkgerät, und
- Figur 3: eine Beschichtungsanlage mit einem über ein Planetengetriebe angetriebenen Substrathalter und einer in die Beschichtungsanlage integrierten Messvorrichtung mit einer Funkvorrichtung zur Übertragung der Messdaten

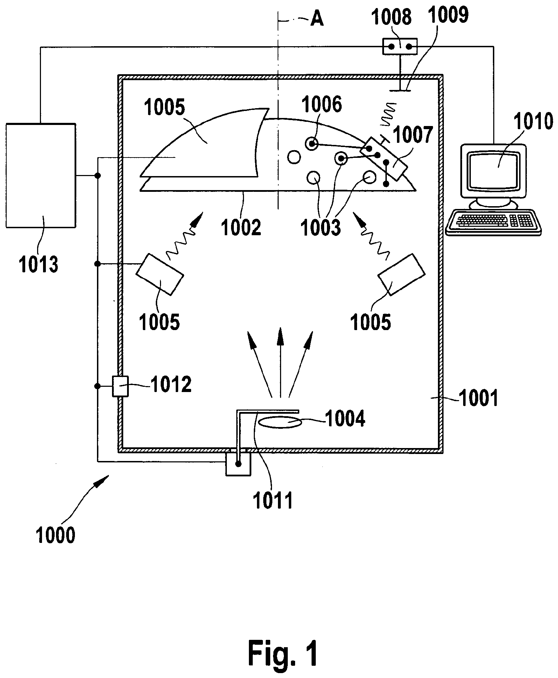

Figur 1 zeigt eine Beschichtungsanlage 1000 gemäß einem Ausführungsbeispiel. Die Beschichtungsanlage 1000 umfasst zumindest eine Beschichtungskammer 1001, in der ein um eine Achse A drehbar angeordneter Substrathalter 1002 angeordnet ist.

Die Beschichtungskammer 1001 kann eine Vakuumkammer sein, die typischerweise auf einen Druck von weniger als 10-5 mbar evakuierbar ist. Während eines Beschichtungsvorganges herrscht in der Beschichtungskammer 1001 typischerweise ein Druck von etwa 10-4 mbar. Eine Erhöhung des Druckes in der Beschichtungskammer 1001 von etwa 10-5 mbar auf etwa 10-4 mbar ist vorzugsweise durch Einlassen von Sauerstoff in die Beschichtungskammer 1001 realisierbar. Der in der Beschichtungskammer 1001 herrschende Gasdruck kann über ein Ventil 1012 erfolgen. Ebenso können andere allgemein gebräuchliche Vorrichtungen zur Regelung eines Gasdruckes, wie z.B. ein Durchflussregler, eine Pumpe o.ä. eingesetzt werden.

Vorzugsweise kann der Substrathalter 1002 in Form einer Drehkalotte ausgestaltet sein. Die Achse A kann in diesem Fall mit der Symmetrieachse der Drehkalotte zusammenfallen. Der Substrathalter 1002 ist zur Aufnahme von zu beschichtenden Substraten 1003 geeignet. Als Substrate sind beliebige Gläser aber auch metallische oder keramische Werkstoffe geeignet. Vorzugsweise kann als Substratglas CaF2 oder Si02 verwendet werden. Ebenso kann als Substrat eines der folgenden Materialien verwendet werden: MgF2, Al203, Zr02, PrTiO3, Ti02, ZnS. Die Beschichtung der Substrate 1003 erfolg gemäß dem in Figur 1 dargestellten Ausführungsbeispiel mittels einer Materialquelle 1004. Die Materialquelle 1004 kann sich im Bodenbereich der Beschichtungskammer 1001 befinden. Bei der Materialquelle 1004 kann es sich um einen Verdampfertiegel, eine Zerstäuberkathode oder eine andere allgemein bekannte, vorzugsweise für Dünnschichtverfahren geeignete Materialquelle 1004 handeln. Ausgehend von der Materialquelle 1004 wird, in Figur 1 durch Pfeile angedeutet, aus dieser austretendes Material in Richtung der Unterseite des Substrathalters 1002 deponiert. Folglich werden die Substrate 1003 von dieser Seite her beschichtet. Der von der Materialquelle 1004 ausgehende Materialstrom kann mit Hilfe einer Blende 1011 unterbrochen werden. Die Blende kann aus einem Blech, welches an einer Achse drehbar befestigt ist bestehen. Zur Unterbrechung des Materialstroms wird die Blende 1011 vor die Austrittsöffnung der Materialquelle geschwenkt.

Die Beschichtung der Substrate 1003 kann, wie in Figur 1 dargestellt, mittels einer einzelnen Materialquelle 1004 erfolgen. Ebenso können mehrere Materialquellen 1004 zur Beschichtung der Substrate 1003 eingesetzt werden. Bei einer Beschichtung der Substrate 1003 mit Hilfe mehrerer Materialquellen 1004 können diese im Bodenbereich der Beschichtungskammer 1001 angeordnet sein. Weiterhin können eine oder mehrere Materialquellen 1004 sowohl im Boden- wie auch im Deckenbereich der Beschichtungskammer 1001 angeordnet sein. Indem mehrere Materialquellen 1004 zur Beschichtung der Substrate 1003 eingesetzt werden, können die Substrate 1003 z.B. mit mehreren Materialkomponenten gleichzeitig beschichtet werden. Durch eine Anordnung einer Materialquelle 1004 im Bodenbereich der Beschichtungskammer 1001 und einer weiteren Materialquelle 1004 im Deckenbereich der Beschichtungskammer 1001 kann eine zweiseitige Beschichtung der Substrate 1003 erreicht werden.

Die Schichtdicken der in der Beschichtungskammer 1001 herzustellenden Schichten können je nach Anforderung an diese Schichten variieren. Die Schichtdicken von einzelnen in der Beschichtungskammer hergestellten Schichten können sich typischerweise von wenigen Nanometern (ca. 1 bis 3 nm) bis hin zu einigen zehn Mikrometern (ca. 20 bis 100 µm) erstrecken.

In der Beschichtungsanlage 1000 können ebenfalls Mehrfachschichtsysteme z.B. für optische Spiegel hergestellt werden. Je nach dem ob ein auf diese Weise hergestellter Spiegel im ultravioletten oder im infraroten Spektralbereich reflektieren soll, variiert die Schichtdicke einer einzelnen Schicht des Mehrfachschichtsystems zwischen etwa 10 nm und etwa 1 bis 2 µm. Die in der Beschichtungskammer 1001 herzustellenden Schichten können weiterhin durch einen während oder nach der Deposition erfolgenden lonenbeschuss verdichtet bzw. nachverdichtet werden.

Der Substrathalter 1002 kann um die Achse A mit einer typischen Umdrehungsgeschwindigkeit von 40 bis 60 Umdrehungen pro Minute, vorzugsweise mit einer Umdrehungsgeschwindigkeit von 30 bis 50 Umdrehungen pro Minute, rotieren. Die Drehung des Substrathalters 1002 ist der gleichmäßigen Beschichtung der Substrate 1003 förderlich. Die Drehgeschwindigkeit kann den jeweiligen Erfordernissen zur Erzielung optimaler Beschichtungsergebnisse auch über die angegebenen Bereiche hinaus angepasst werden.

Zur weiteren gezielten Beeinflussung der Depositionsbedingungen sind in der Beschichtungskammer 1001 Heizungen 1005 angeordnet. Die Heizungen 1005 können in beliebiger Position zu dem Substrathalter 1002 in der Beschichtungskammer installiert sein. Als Heizung 1005 können vorzugsweise Strahlungsheizungen aber auch andere allgemein bekannte Heizungen verwendet werden. Die Heizung 1005 kann im unteren Bereich der Beschichtungskammer 1001 angeordnet sein. Sie kann ebenfalls die Form eines Heizschildes haben, der sich oberhalb des Substrathalters 1002 erstreckt. Die Heizungen 1005 sind mittels eines außerhalb der Beschichtungskammer 1001 aufgestellten Steuergerätes 1006 steuer- und /oder regelbar.

Die Temperatur der Substrate 1003 kann mit Hilfe einer allgemein mit 1007 bezeichneten Messvorrichtung gemessen werden. Die Messvorrichtung 1007 ist auf dem drehbaren Substrathalter 1002 montiert.

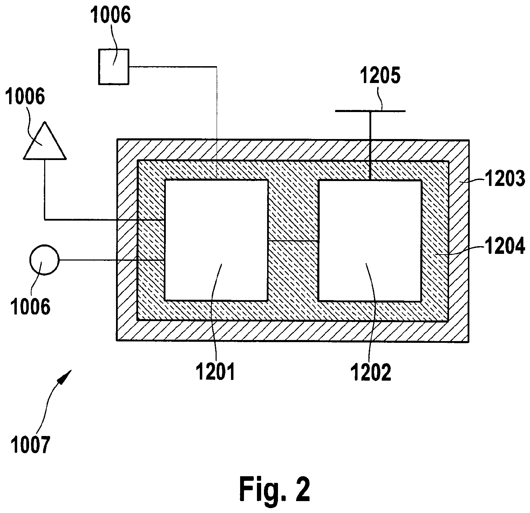

Im Folgenden werden weitere Einzelheiten hinsichtlich des Aufbaus der Messvorrichtung 1007 im Zusammenhang mit Figur 2 erläutert.

Figur 2 zeigt den Aufbau der allgemein mit 1007 bezeichneten Messvorrichtung. Die Messvorrichtung besteht zumindest aus einem Messgerät 1201 und einem ersten Funkgerät 1202. Das Messgerät 1201 und das Funkgerät 1202 sind zum Austausch von Informationen miteinander verbunden. Die Messvorrichtung 1007 weist weiterhin zumindest eine einzelne, vorzugsweise mehrere Messsonden 1006 auf, mit denen insbesondere die Temperatur eines oder mehrerer Substrate 1003 gemessen werden kann. Vorzugsweise kann als eine solche Temperaturmesssonde ein Thermoelement z.B. ein Ni/NiCr - Thermoelement verwendet werden. Die Messsonden 1006 sind mit dem Messgerät 1201 verbunden.

Gemäß weiteren Ausführungsbeispielen können mit Hilfe der Messvorrichtung 1007 weitere physikalische Größen innerhalb der Beschichtungskammer 1001 gemessen werden. Zu diesem Zweck können weitere Messsonden 1006 mit dem Messgerät 1201 verbunden sein. Diese weiteren Messsonden 1006 können zur Messung von Gasdrücken, Stromstärken, Spannungen, Widerständen, Kräften und/oder weiteren physikalischen Größen geeignet sein. Die Messsonden 1006 können direkt in Kontakt mit den Substraten 1003, oder der auf die Substrate 1003 deponierten Schicht gebracht werden. Ebenso können die Messsonden 1006 in die Nähe der Substrate 1003 gebracht werden und/oder in thermischem oder mechanischem Kontakt mit dem Substrathalter 1002 stehen.

Eine komplexe Messsonde 1006 kann ein Schwingquarz zur Bestimmung einer Schichtdicke sein. Die Frequenz des Schwingquarzes kann mit Hilfe des Messgerätes 1201 ausgelesen werden. Auf diese Weise kann die deponierte Masse bzw. die deponierte Schichtdicke direkt an einem definierten Ort auf dem Substrathalter 1002 gemessen werden. Eine weitere Möglichkeit für die Ausgestaltung einer Messsonde 1006 ist eine Einrichtung mit der die auf einem Substrat 1003 deponierte Schichtdicke gemessen werden kann. Dies kann beispielsweise mit Hilfe einer interferrometrischen Messung erfolgen. In diesem Fall besteht die Messonde 1006 zumindest aus einer Lichtquelle z.B. einer LED oder Laserdiode und einem Photodetektor. Die Messung der Schichtdicke auf einem Substrat 1003 erfolgt, wie allgemein aus dem Stand der Technik bekannt, anhand der Analyse der Intensitätsmaxima und Minima des an der entsprechenden Schicht reflektierten Lichtanteils der Lichtquelle.

Ein von einer oder mehreren Messsonden 1006 aufgenommener Messwert oder mehrere Messwerte, vorzugsweise ein Temperaturwert, kann mit Hilfe des ersten Funkgerätes 1202 an einen Punkt außerhalb der Beschichtungskammer 1001 übertragen werden.

Vorzugsweise sind das Messgerät 1201 und das erste Funkgerät 1202 in einem gemeinsamen Gehäuse 1203 untergebracht, welches zusätzlich mit Mitteln 1204 zur thermischen Isolierung ausgestattet ist.

Der Messwert kann mittels einer Funkverbindung, vorzugsweise einer digitalen Funkverbindung, von dem ersten Funkgerät 1202 an ein zweites Funkgerät 1008 übertragen werden. Zu diesem Zweck kann das erste Funkgerät 1202 mit einer außerhalb des Gehäuses 1203 angebrachten Antenne 1205 verbunden sein. Die mit dem Funkgerät 1202 verbundene Antenne 1205 kann ebenfalls innerhalb des Gehäuses 1203 angeordnet sein. Das Gehäuse 1203 der Messvorrichtung 1007 kann insbesondere vakuumisoliert ausgestaltet sein.

Die weiteren Erläuterungen werden erneut anhand von Figur 1 vorgenommen.

Das zweite Funkgerät 1008 befindet sich zumindest teilweise außerhalb der Beschichtungskammer 1001. Zur Übertragung von Informationen und Daten über die Funkverbindung kann bzw. können eine oder mehrere Antennen 1009 innerhalb der Beschichtungskammer 1001 angebracht sein, welche mit dem zweiten Funkgerät 1008 verbunden sind. Die Funkverbindung kann sowohl monodirektional aufgebaut sein, d.h. eines der beiden Funkgeräte 1202, 1008 ist stets Sender und das entsprechend andere Funkgerät stets Empfänger, als auch bidirektional, d.h. beide Funkgeräte 1202,1008 sind sowohl Sender als auch Empfänger. Weiterhin kann es sich bei der Funkverbindung um eine analoge oder digitale Funkverbindung handeln, die sowohl bidirektional als auch monodirektional sein kann. Vorzugsweise handelt es sich bei der Funkverbindung um eine digitale Funkverbindung mit einer Frequenz von in etwa 869 MHz, 422 MHz oder 2,4 GHz.

Der auf die vorbeschriebene Weise aus der Beschichtungskammer 1001 an das zweite Funkgerät 1008 übertragene Messwert kann zur weiteren Verarbeitung oder Darstellung des Messwertes an einen Computer 1010 übertragen werden. Der Messwert kann ebenfalls als Eingangsgröße für die Steuerung 1006 der in der Beschichtungskammer 1001 angeordneten Heizung oder Heizungen 1005 dienen. Auf diese Weise kann vorzugsweise eine rückgekoppelte Steuerung einer Substrattemperatur erfolgen.

Die rückgekoppelte Steuerung der Substrattemperatur wird im Folgenden näher beschrieben. Die Temperatur in der Beschichtungsanlage 1000 kann mittels eines an das Messgerät 1201 angeschlossenen Temperaturfühlers gemessen werden. Der Temperaturwert wird von dem Temperaturfühler an das Messgerät 1201 übertragen, dieses überträgt den Messwert an das erste Funkgerät 1202. Das erste Funkgerät 1202 kommuniziert den Messwert an das zweite Funkgerät 1008. Von dort wird der Messwert einer weiteren Verarbeitung zugeführt. Die Verarbeitung kann z.B. mit Hilfe eins Computers 1010 erfolgen. Basierend auf dem in der Beschichtungskammer 1001 direkt an dem sich auf dem rotierenden Substrathalter 1002 befindlichen Substrat 1003 gemessenen Temperaturwertes kann über die Steuerung 1006 die in der Beschichtungskammer 1001 befindliche Heizung oder Heizungen 1005 gesteuert werden. Auf diese Weise kann eine sehr genaue Regelung der Substrattemperatur erfolgen. Typische Substrattemperaturen liegen bei etwa 100°C bis 300°C, vorzugsweise bei 120°C bis 150°C oder 200° bis 300°C. In ähnlicher Weise wie zuvor für die Steuerung der Substrattemperatur beschrieben kann auch die Steuerung und/oder Regelung von anderen Größen erfolgen. So können beispielsweise der innerhalb der Beschichtungskammer 1001 herrschende Gasdruck, die Betriebsparameter der Materialquelle 1004 oder eine Blende 1011, die die Materialquelle abschattet, gesteuert werden.

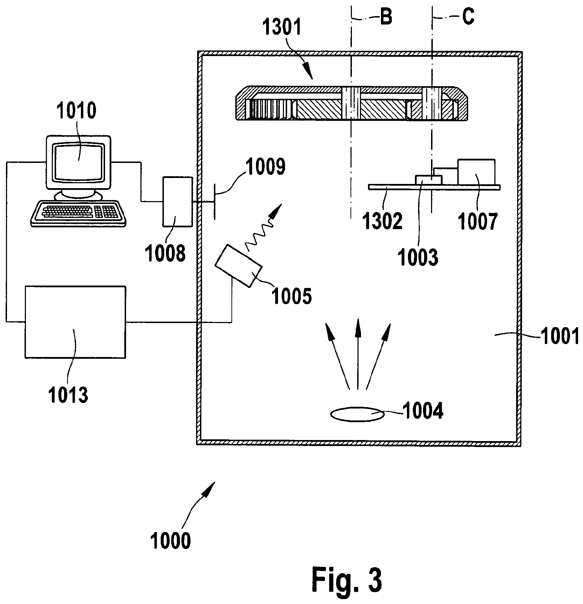

Figur 3 zeigt ein weiteres bevorzugtes Ausführungsbeispiel einer Beschichtungsanlage 1000 mit einer Messvorrichtung 1007. Gegenüber dem aus Figur 1 bekannten Ausführungsbeispiel ist in der Beschichtungskammer 1001 ein Planetengetriebe 1301 angeordnet. Dieses Planetengetriebe 1301 ist um eine Achse B drehbar gelagert. Mit Hilfe des Planetengetriebes 1301 kann ein Substrathalter 1302 in eine Drehung um eine Achse C versetzt werden. Das Planetengetriebe kann zum Antrieb eines oder mehrerer Substrathalter 1302 geeignet sein. Die Achsen B und C können weiterhin vorzugsweise parallel verlaufen. In gleicher oder sehr ähnlicher Weise wie im Zusammenhang mit den in Figur 1 und 2 gezeigten Ausführungsbeispielen kann auch bei dem in Figur 3 gezeigten Ausführungsbeispiel eine Regelung z.B. einer Substrattemperatur erfolgen. Weiterhin sind auch andere Größen regelbar, so z.B. der in der Beschichtungskammer 1001 herrschende Druck, die Parameter der Materialquelle 1004 etc.

## Patentansprüche

1. Beschichtungsanlage (1000) mit
- einer Beschichtungskammer (1001) und mindestens einem innerhalb der Beschichtungskammer (1001) bewegbar angeordneten Substrathalter (1002) zur Aufnahme von zu beschichtenden Substraten (1003), und
- einem Messgerät (1201) zur Aufnahme von Messwerten innerhalb der Beschichtungskammer (1001), welches mit dem Substrathalter (1002) verbunden ist, und
- einer Funkvorrichtung mit mindestens
--einem ersten Funkgerät (1202), welches mit dem Substrathalter (1002) verbunden ist, und
--einem zweiten Funkgerät (1008), welches zumindest teilweise außerhalb der Beschichtungskammer (1001) angeordnet ist,
wobei
zumindest zeitweise eine Funkverbindung zur Übertragung der Messwerte zwischen dem ersten (1202) und dem zweiten Funkgerät (1008) besteht, und
mindestens das erste Funkgerät (1202) und/oder das Messgerät (1201) mit Mitteln (1204) zur thermischen Isolation ausgestattet sind/ist.

2. Beschichtungsanlage (1000) gemäß Anspruch 1, **dadurch gekennzeichnet, dass** mindestens das erste Funkgerät (1202) und/oder das Messgerät (1201) in einem vakuumisolierten Gehäuse untergebracht sind/ist.

3. Beschichtungsanlage (1000) gemäß Anspruch 1, **dadurch gekennzeichnet, dass** der Substrathalter (1002) als eine um eine Achse (A) drehbare Kalotte ausgestaltet ist.

4. Beschichtungsanlage (1000) gemäß Anspruch 1, **dadurch gekennzeichnet, dass** in der Beschichtungskammer (1001) ein um eine Hauptachse (B) drehbares Planetengetriebe (1301) angeordnet ist, welches dazu geeignet ist mindestens den mit dem Planetengetriebe (1301) verbundenen Substrathalter (1302) in eine Drehung um eine Achse (C) zu versetzen, welche im wesentlichen parallel zu der Hauptachse (B) orientiert ist.

5. Beschichtungsanlage (1000) gemäß einem der vorstehenden Ansprüche, **dadurch gekennzeichnet, dass** das Messgerät (1201) zur Messung mindestens einer physikalischen Größe aus einer Gruppe von physikalischen Größen, bestehend aus einer Substrattemperatur, einem Gasdruck, einer elektrischen Spannung, einem elektrischen Widerstand oder einer Schichtdicke einer auf einem zu beschichtenden Substrat (1003) abgeschiedenen Schicht, geeignet ist.

6. Beschichtungsanlage (1000) gemäß Anspruch 5, **dadurch gekennzeichnet, dass** die Beschichtungsanlage (1000) eine außerhalb der Beschichtungskammer (1001) angeordnete Steuereinheit (1006) umfasst, und zur Steuerung einer innerhalb der Beschichtungskammer (1001) angeordneten Heizung (1005), die mit der Beschichtungskammer (1001) verbunden ist, zumindest eine physikalische Größe ein Steuerparameter der Heizung (1005) ist.

7. Beschichtungsanlage (1000) gemäß Anspruch 5, **dadurch gekennzeichnet, dass** die Beschichtungsanlage (1000) eine außerhalb der Beschichtungskammer (1001) angeordnete Steuereinheit (1006) umfasst, und zur Steuerung eines innerhalb der Beschichtungskammer (1001) herrschenden Gasdrucks zumindest eine physikalische Größe ein Steuerparameter des Gasdrucks ist.

8. Beschichtungsanlage (1000) gemäß Anspruch 5, **dadurch gekennzeichnet, dass** die Beschichtungsanlage (1000) eine außerhalb der Beschichtungskammer (1001) angeordnete Steuereinheit (1006) umfasst, und zur Steuerung einer innerhalb der Beschichtungskammer (1001) angeordneten Materialquelle (1004), die mit der Beschichtungskammer (1001) verbunden ist, zumindest eine physikalische Größe ein Steuerparameter der Materialquelle (1004) ist.

9. Beschichtungsanlage (1000) gemäß Anspruch 5, **dadurch gekennzeichnet, dass** die Beschichtungsanlage (1000) eine außerhalb der Beschichtungskammer (1001) angeordnete Steuereinheit (1006) umfasst, und zur Steuerung einer innerhalb der Beschichtungskammer (1001) angeordneten Blende (1011) zur Abschattung der Materialquelle (1004), die mit der Beschichtungskammer (1001) verbunden ist, zumindest eine physikalische Größe ein Steuerparameter der Blende (1011) ist.

10. Beschichtungsanlage (1000) gemäß einem der vorstehenden Ansprüche, **dadurch gekennzeichnet, dass** mindestens das erste Funkgerät (1202) und das Messgerät (1201) in einem gemeinsamen Gehäuse (1203) untergebracht sind.

11. Beschichtungsanlage (1000) gemäß einem der vorstehenden Ansprüche, **dadurch gekennzeichnet, dass** die Trägerfrequenz der Funkverbindung eine ISM -Frequenz ist.

12. Beschichtungsanlage (1000) gemäß Anspruch 11, **dadurch gekennzeichnet, dass** die Trägerfrequenz 27 MHz, 40 MHz, 446 MHz 860 MHz oder 2,45 GHz beträgt.

13. Beschichtungsanlage (1000) gemäß einem der Ansprüche 1 bis 12, **dadurch gekennzeichnet, dass** die Funkverbindung eine digitale Funkverbindung ist.

14. Beschichtungsanlage (1000) gemäß einem der vorstehenden Ansprüche, **dadurch gekennzeichnet, dass** die Beschichtungskammer (1001) eine Vakuumkammer, vorzugsweise eine Hochvakuum- oder Ultrahochvakuumkammer ist.

15. Beschichtungsanlage (1000) gemäß einem der vorstehenden Ansprüche, **dadurch gekennzeichnet, dass** die Substrate (1003) mit einer dünnen Schicht beschichtbar sind, die eine Schichtdicke zwischen 3 nm und 100 µm, vorzugsweise eine Schichtdicke zwischen 50 nm und 15 µm aufweist.

16. Beschichtungsanlage (1000) gemäß einem der vorstehenden Ansprüche, **dadurch gekennzeichnet, dass** die Substrate mit einem Material beschichtbar sind, welches mindestens eine oxidische Materialkomponente aus einer Gruppe von Materialkomponenten, bestehende aus SiO₂, TiO₂, HfO, TaO, MgF₂, Al₂O₃, ZrO₂, PrTiO₃, ZnS, enthält.

17. Beschichtungsanlage (1000) gemäß einem der vorstehenden Ansprüche, **dadurch gekennzeichnet, dass** die Substrate mit einem metallischen Material beschichtbar sind.

18. Beschichtungsanlage (1000) gemäß einem der vorstehenden Ansprüche, **dadurch gekennzeichnet, dass** die Substrate (1003) mit einem Mehrfachschichtsystem aus verschiedenen Materialien beschichtbar sind.

## Claims

1. Coating installation (1000) comprising
- a coating chamber (1001) and at least one substrate holder (1002) for receiving substrates (1003) to be coated that is movably arranged inside the coating chamber (1001), and
- a measuring instrument (1201) for recording measured values inside the coating chamber (1001) that is connected to the substrate holder (1002), and
- a radio device with at least
-- a first radio set (1202), which is connected to the substrate holder (1002), and
-- a second radio set (1008), which is arranged at least partially outside the coating chamber (1001),
wherein
a radio link for the transmission of the measured values between the first radio set (1202) and the second radio set (1008) exists at least for a time, and
at least the first radio set (1202) and/or the measuring instrument (1201) are/is equipped with means (1204) for thermal insulation.

2. Coating installation (1000) according to Claim 1, **characterized in that** at least the first radio set (1202) and/or the measuring instrument (1201) are/is accommodated in a vacuum-insulated housing.

3. Coating installation (1000) according to Claim 1, **characterized in that** the substrate holder (1002) is designed as a spherical cap that is rotatable about an axis (A).

4. Coating installation (1000) according to Claim 1, **characterized in that** a planetary gearing (1301) that is rotatable about a main axis (B) is arranged in the coating chamber (1001) and is suitable for setting at least the substrate holder (1302) connected to the planetary gearing (1301) in a rotation about an axis (C), which is oriented substantially parallel to the main axis (B).

5. Coating installation (1000) according to one of the preceding claims, **characterized in that** the measuring instrument (1201) is suitable for measuring at least one physical variable from a group of physical variables consisting of a substrate temperature, a gas pressure, an electrical voltage, an electrical resistance or a layer thickness of a layer deposited on a substrate (1003) to be coated.

6. Coating installation (1000) according to Claim 5, **characterized in that** the coating installation (1000) comprises a control unit (1006) arranged outside the coating chamber (1001), and, for controlling a heating (1005), which is arranged inside the coating chamber (1001) and is connected to the coating chamber (1001), at least one physical variable is a control parameter of the heating (1005).

7. Coating installation (1000) according to Claim 5, **characterized in that** the coating installation (1000) comprises a control unit (1006) arranged outside the coating chamber (1001), and, for controlling a gas pressure prevailing within the coating chamber (1001), at least one physical variable is a control parameter of the gas pressure.

8. Coating installation (1000) according to Claim 5, **characterized in that** the coating installation (1000) comprises a control unit (1006) arranged outside the coating chamber (1001), and, for controlling a material source (1004), which is arranged inside the coating chamber (1001) and is connected to the coating chamber (1001), at least one physical variable is a control parameter of the material source (1004).

9. Coating installation (1000) according to Claim 5, **characterized in that** the coating installation (1000) comprises a control unit (1006) arranged outside the coating chamber (1001), and, for controlling a shutter (1011), which is arranged inside the coating chamber (1001), is intended for blanking out the material source (1004) and is connected to the coating chamber (1001), at least one physical variable is a control parameter of the shutter (1011).

10. Coating installation (1000) according to one of the preceding claims, **characterized in that** at least the first radio set (1202) and the measuring instrument (1201) are accommodated in a common housing (1203).

11. Coating installation (1000) according to one of the preceding claims, **characterized in that** the carrier frequency of the radio link is an ISM frequency.

12. Coating installation (1000) according to Claim 11, **characterized in that** the carrier frequency is 27 MHz, 40 MHz, 446 MHz, 860 MHz or 2.45 GHz.

13. Coating installation (1000) according to one of Claims 1 to 12, **characterized in that** the radio link is a digital radio link.

14. Coating installation (1000) according to one of the preceding claims, **characterized in that** the coating chamber (1001) is a vacuum chamber, preferably a high-vacuum or ultrahigh-vacuum chamber.

15. Coating installation (1000) according to one of the preceding claims, **characterized in that** the substrates (1003) can be coated with a thin layer, which has a layer thickness of between 3 nm and 100 µm, preferably a layer thickness of between 50 nm and 15 µm.

16. Coating installation (1000) according to one of the preceding claims, **characterized in that** the substrates can be coated with a material which contains at least one oxidic material component from a group of material components consisting of SiO₂, TiO₂, HfO, TaO, MgF₂, Al₂O₃, ZrO₂, PrTiO₃ and ZnS.

17. Coating installation (1000) according to one of the preceding claims, **characterized in that** the substrates can be coated with a metallic material.

18. Coating installation (1000) according to one of the preceding claims, **characterized in that** the substrates (1003) can be coated with a multilayer system comprising different materials.

## Revendications

1. Équipement d'enduction (1000) comprenant
- une chambre d'enduction (1001) et au moins un support de substrat (1002) monté mobile à l'intérieur de la chambre d'enduction (1001) et destiné à accueillir des substrats (1003) à enduire, et
- un appareil de mesure (1201) destiné à enregistrer des valeurs mesurées à l'intérieur de la chambre d'enduction (1001), lequel est relié au support de substrat (1002), et
- un dispositif radioélectrique comprenant au moins
-- un premier appareil radioélectrique (1202) qui est relié au support de substrat (1002), et
-- un deuxième appareil radioélectrique (1008) qui est disposé au moins partiellement à l'extérieur de la chambre d'enduction (1001),
une liaison radioélectrique destinée à la transmission des valeurs mesurées étant établie au moins temporairement entre le premier (1202) et le deuxième appareil radioélectrique (1008), et
au moins le premier appareil radioélectrique (1202) et/ou l'appareil de mesure (1201) étant équipé(s) de moyens (1204) destinés à l'isolation thermique.

2. Équipement d'enduction (1000) selon la revendication 1, **caractérisé en ce qu'**au moins le premier appareil radioélectrique (1202) et/ou l'appareil de mesure (1201) est/sont logé(s) dans un boîtier isolé sous vide.

3. Équipement d'enduction (1000) selon la revendication 1, **caractérisé en ce que** le support de substrat (1002) est réalisé sous la forme d'une calotte pouvant tourner autour d'un axe (A).

4. Équipement d'enduction (1000) selon la revendication 1, **caractérisé en ce qu'**un engrenage planétaire (1301) pouvant tourner autour d'un axe principal (B) est disposé dans la chambre d'enduction (1001), lequel est conçu pour amener en rotation au moins le support de substrat (1302), qui est relié à l'engrenage planétaire (1301), autour d'un axe (C) qui est orienté sensiblement parallèlement à l'axe principal (B).

5. Équipement d'enduction (1000) selon l'une des revendications précédentes, **caractérisé en ce que** l'appareil de mesure (1201) est conçu pour mesurer au moins une grandeur physique issue d'un groupe de grandeurs physiques composé d'une température de substrat, d'une pression de gaz, d'une tension électrique, d'une résistance électrique ou d'une épaisseur de couche d'une couche déposée sur un substrat (1003) à enduire.

6. Équipement d'enduction (1000) selon la revendication 5, **caractérisé en ce que** l'équipement d'enduction (1000) comporte une unité de commande (1006) disposée à l'extérieur de la chambre d'enduction (1001) et en vue de la commande d'un dispositif de chauffage (1005) disposé à l'intérieur de la chambre d'enduction (1001), lequel est relié à la chambre d'enduction (1001), au moins une grandeur physique est un paramètre de commande du dispositif de chauffage (1005).

7. Équipement d'enduction (1000) selon la revendication 5, **caractérisé en ce que** l'équipement d'enduction (1000) comporte une unité de commande (1006) disposée à l'extérieur de la chambre d'enduction (1001) et en vue de la commande d'une pression de gaz qui règne à l'intérieur de la chambre d'enduction (1001), au moins une grandeur physique est un paramètre de commande de la pression de gaz.

8. Équipement d'enduction (1000) selon la revendication 5, **caractérisé en ce que** l'équipement d'enduction (1000) comporte une unité de commande (1006) disposée à l'extérieur de la chambre d'enduction (1001) et en vue de la commande d'une source de matériau (1004) disposée à l'intérieur de la chambre d'enduction (1001), laquelle est reliée à la chambre d'enduction (1001), au moins une grandeur physique est un paramètre de commande de la source de matériau (1004).

9. Équipement d'enduction (1000) selon la revendication 5, **caractérisé en ce que** l'équipement d'enduction (1000) comporte une unité de commande (1006) disposée à l'extérieur de la chambre d'enduction (1001) et en vue de la commande d'un écran (1011) disposé à l'intérieur de la chambre d'enduction (1001) et destiné à masquer la source de matériau (1004), lequel est relié à la chambre d'enduction (1001), au moins une grandeur physique est un paramètre de commande de l'écran (1011).

10. Équipement d'enduction (1000) selon l'une des revendications précédentes, **caractérisé en ce qu'**au moins le premier appareil radioélectrique (1202) et l'appareil de mesure (1201) sont logés dans un boîtier (1203) commun.

11. Équipement d'enduction (1000) selon l'une des revendications précédentes, **caractérisé en ce que** la fréquence porteuse de la liaison radioélectrique est une fréquence ISM.

12. Équipement d'enduction (1000) selon la revendication 11, **caractérisé en ce que** la fréquence porteuse est de 27 MHz, 40 MHz, 446 MHz, 860 MHz ou 2,45 GHz.

13. Équipement d'enduction (1000) selon l'une des revendications 1 à 12, **caractérisé en ce que** la liaison radioélectrique est une liaison radioélectrique numérique.

14. Équipement d'enduction (1000) selon l'une des revendications précédentes, **caractérisé en ce que** la chambre d'enduction (1001) est une chambre sous vide, de préférence une chambre sous vide poussé ou sous vide très poussé.

15. Équipement d'enduction (1000) selon l'une des revendications précédentes, **caractérisé en ce que** les substrats (1003) peuvent être enduits d'une mince couche qui présente une épaisseur de couche entre 3 nm et 100 µm, de préférence une épaisseur de couche entre 50 nm et 15 µm.

16. Équipement d'enduction (1000) selon l'une des revendications précédentes, **caractérisé en ce que** les substrats peuvent être enduits d'un matériau qui contient au moins une composante de matériau oxydique issue d'un groupe de composantes de matériau composé du SiO₂, TiO₂, HfO, TaO, MgF₂, Al₂O₃, ZrO₂, PrTiO₃, ZnS.

17. Équipement d'enduction (1000) selon l'une des revendications précédentes, **caractérisé en ce que** les substrats peuvent être enduits d'un matériau métallique.

18. Équipement d'enduction (1000) selon l'une des revendications précédentes, **caractérisé en ce que** les substrats (1003) peuvent être enduits d'un système multicouche composé de différents matériaux.
